# EUROPEAN PATENT APPLICATION

(11) **EP 4 590 079 A1**
(43) Date of publication of application: **23.07.2025**
(21) Application number: 22958798.5
(22) Date of filing: 15.09.2022
(51) Int. Cl.: H05K 3/28

(54) **DEVICE FOR FORMING RESIN LAMINATE, CIRCUIT BOARD, AND METHOD FOR FORMING CIRCUIT BOARD**

(71) Applicant: Fuji Corporation, Chiryu-shi, Aichi 472-8686 (JP)
(72) Inventor: TAKIKAWA, Shinji, Chiryu-shi, Aichi 472-8686 (JP); TOMINAGA, Ryojiro, Chiryu-shi, Aichi 472-8686 (JP); HIRAMATSU, Naohiko, Chiryu-shi, Aichi 472-8686 (JP)
(74) Representative: Grünecker Patent- und Rechtsanwälte PartG mbB
(86) International application number: PCT/JP2022/034541
(87) International publication number: WO 2024/057474

(57) **Abstract**

A resin laminate forming device in which a resin laminate is formed to extend upward from an upper surface of a component mounted in a cavity formed in a base in a state in which the upper surface of the component is exposed by ejecting a curable resin to surround a side surface of the component and to cover an upper surface of the base.

## Description

### Technical Field

The present invention relates to a device for forming a resin laminate, a circuit board, and a method for forming a circuit board.

### Background Art

Patent Literature 1 below describes a technique relating to a circuit board including a component mounted on a base.

### Citation List

### Patent Literature

Patent Literature 1:JP-A-2017-130553

### Summary of the Invention

### Technical Problem

An object of the present invention is to appropriately form a circuit board including a component mounted on a base.

### Solution to Problem

In order to solve the above problems, the present description discloses a resin laminate forming device, in which a resin laminate is formed to extend upward from an upper surface of a component mounted in a cavity formed in a base in a state in which the upper surface of the component is exposed by ejecting a curable resin to surround a side surface of the component and to cover an upper surface of the base.

Further, the present description discloses a circuit board including a base having a cavity; a component mounted in the cavity; and a resin laminate formed of a curable resin ejected to surround a side surface of the component and to cover an upper surface of the base, in which the resin laminate extends upward from an upper surface of the component in a state in which the upper surface of the component is exposed.

In addition, the present description discloses a circuit board forming method including a mounting step of mounting a component in a cavity formed in a base; and a resin laminate forming step of forming a resin laminate that extends upward from an upper surface of the component in a state in which the upper surface of the component is exposed by ejecting a curable resin to surround a side surface of the component and to cover an upper surface of the base.

### Advantageous Effects of Invention

In the present disclosure, a resin laminate is formed of a component mounted in a cavity and a curable resin ejected to surround a side surface of the component and to cover an upper surface of a base. The resin laminate extends upward from an upper surface of the component in a state in which the upper surface of the component is exposed. Accordingly, for example, the component can be protected by the resin laminate, and the circuit board can be appropriately formed.

### Brief Description of Drawings

Fig. 1 is a diagram illustrating a circuit formation device.
Fig. 2 is a block diagram illustrating a control device.
Fig. 3 is a cross-sectional view illustrating a circuit board in a state in which a resin laminate is formed.
Fig. 4 is a cross-sectional view illustrating the circuit board in a state in which a wiring line is formed on the resin laminate.
Fig. 5 is a cross-sectional view illustrating the circuit board in a state in which the resin laminate is further formed on the resin laminate.
Fig. 6 is a cross-sectional view illustrating the circuit board in a state in which a conductive paste is applied onto the wiring line.
Fig. 7 is a cross-sectional view illustrating the circuit board in a state in which an electronic component is mounted.
Fig. 8 is a cross-sectional view illustrating the circuit board in a state in which a thermosetting resin is ejected into a cavity.
Fig. 9 is a cross-sectional view illustrating the circuit board in a state in which all the electronic components are sealed.
Fig. 10 is a cross-sectional view illustrating the circuit board in a state in which general component and functional component are sealed.
Fig. 11 is a cross-sectional view illustrating the circuit board in a state in which the general component is sealed and the functional component exposes the functional section.
Fig. 12 is a plan view illustrating a resin laminate on which the general component and the functional component are mounted.
Fig. 13 is a diagram illustrating image data of a resin laminate covering the resin laminate of Fig. 12.
Fig. 14 is an enlarged view illustrating the functional section of the functional component exposed from an opening of the resin laminate.
Fig. 15 is a cross-sectional view illustrating the circuit board in a state in which the general component is sealed and an upper surface of the functional component is exposed.
Fig. 16 is a cross-sectional view illustrating the circuit board in a state in which the general component is sealed and the upper surface of the functional component is exposed.
Fig. 17 is an enlarged view illustrating the functional section of the functional component exposed from the opening of the resin laminate.
Fig. 18 is an enlarged view illustrating a functional section of the functional component exposed from the opening of the resin laminate.

### Description of Embodiments

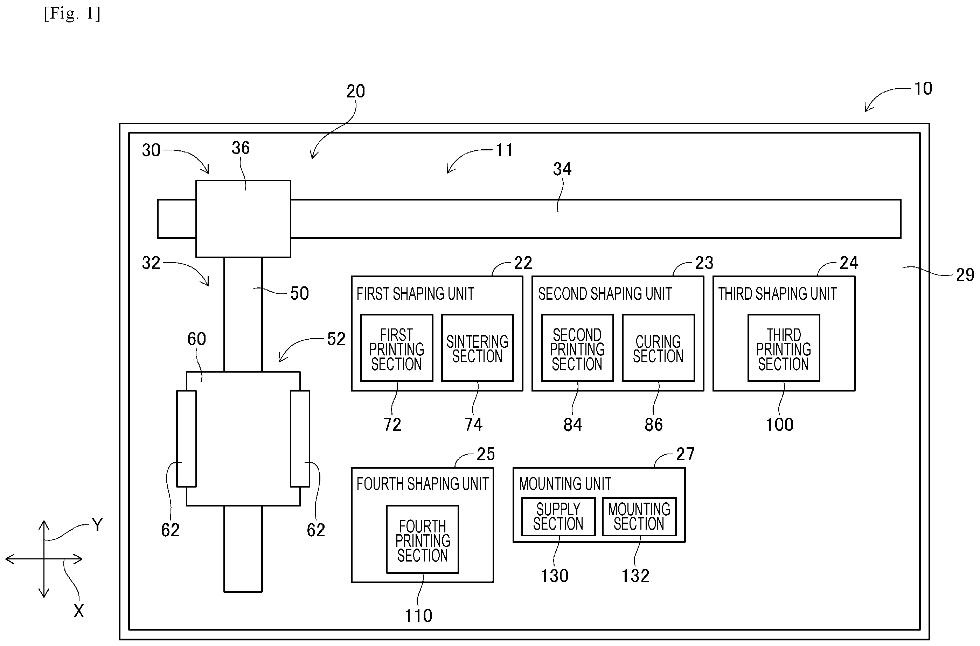

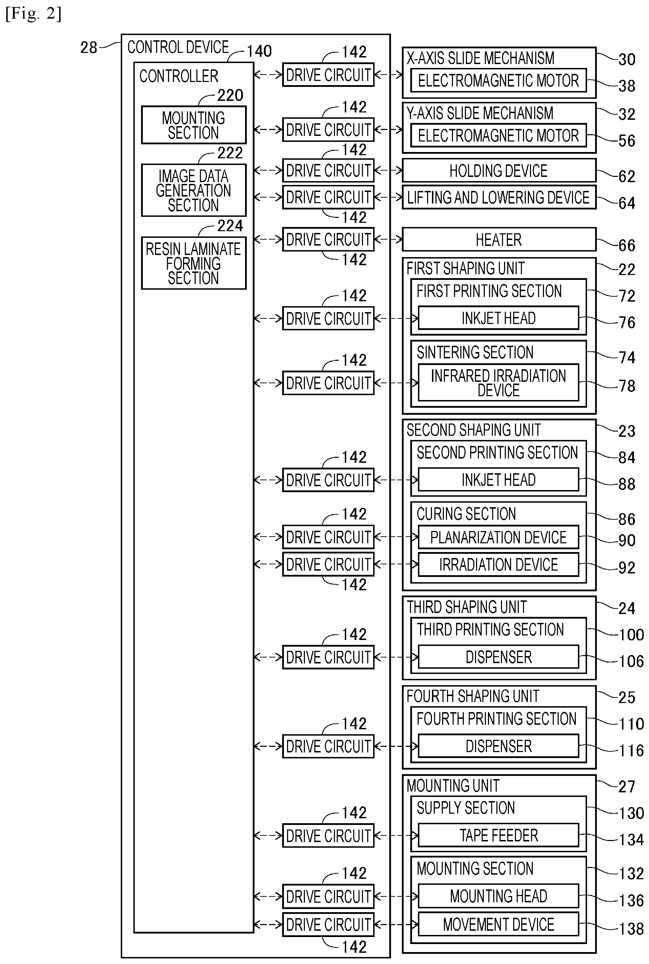

Fig. 1 illustrates an example of circuit formation device 10. Circuit formation device 10 includes conveyance device 20, first shaping unit 22, second shaping unit 23, third shaping unit 24, fourth shaping unit 25, mounting unit 27, and control device 28 (refer to Fig. 2). Conveyance device 20, first shaping unit 22, second shaping unit 23, third shaping unit 24, fourth shaping unit 25, and mounting unit 27 are disposed on base 29 of circuit formation device 10. Base 29 is generally rectangular in shape, and in the following description, a longitudinal direction of base 29 will be referred to as an X-axis direction, a transverse direction of base 29 will be referred to as a Y-axis direction, and a direction orthogonal to both the X-axis direction and the Y-axis direction will be referred to as a Z-axis direction.

Conveyance device 20 includes X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. Further, X-axis slide mechanism 30 includes electromagnetic motor (refer to Fig. 2) 38, and X-axis slider 36 moves to any position in the X-axis direction by the drive of electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end part of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor (refer to Fig. 2) 56, and stage 52 moves to any position in the Y-axis direction by the drive of electromagnetic motor 56. As a result, stage 52 moves to any position on base 29 by the drive of X-axis slide mechanism 30 and Y-axis slide mechanism 32.

Stage 52 includes base plate 60, holding device 62, lifting and lowering device (refer to Fig. 2) 64, and heater (refer to Fig. 2) 66. Base plate 60 is formed in a flat plate shape, and a board is placed on an upper surface thereof. Holding device 62 is provided on both side parts of base plate 60 in the X-axis direction. Both edge parts of the board placed on base plate 60 in the X-axis direction are sandwiched by holding device 62, thereby fixedly holding the board. In addition, lifting and lowering device 64 is disposed below base plate 60 to lift and lower base plate 60. Further, heater 66 is incorporated into base plate 60 and heats the board placed on base plate 60 to any temperature.

First shaping unit 22 is a unit that shapes a wiring line of a circuit board, and includes first printing section 72 and sintering section 74. First printing section 72 includes inkjet head (refer to Fig. 2) 76, and inkjet head 76 linearly ejects metal ink. The metal ink is metal ink in which nanometer-sized metal fine particles, for example, silver fine particles, are dispersed in a solvent. Surfaces of the metal fine particles are coated with a dispersant to prevent aggregation in the solvent. Additionally, inkjet head 76 ejects the metal ink from multiple nozzles through, for example, a piezoelectric method using a piezoelectric element.

Sintering section 74 includes infrared irradiation device (refer to Fig. 2) 78. Infrared irradiation device 78 is a device that irradiates the ejected metal ink with infrared rays. The metal ink irradiated with the infrared rays is subjected to sintering, thereby forming the wiring line. Sintering of the metal ink is a phenomenon in which applying energy causes the solvent to evaporate, the protective films of the metal fine particles, that is, the dispersant, to break down, or the like so that the metal fine particles come into contact with or fuse each other, thereby increasing the conductivity. The metal ink is sintered to form a metal wiring line.

In addition, second shaping unit 23 is a unit that shapes a resin layer of the circuit board, and includes second printing section 84 and curing section 86. Second printing section 84 includes inkjet head (refer to Fig. 2) 88, and inkjet head 88 ejects an ultraviolet curable resin. The ultraviolet curable resin is a resin to be cured by irradiation with ultraviolet rays. Inkjet head 88 may employ, for example, a piezoelectric method using the piezoelectric element, or may be a thermal type in which the resin is heated to generate bubbles which are ejected from multiple nozzles.

Curing section 86 includes planarization device (refer to Fig. 2) 90 and irradiation device (refer to Fig. 2) 92. Planarization device 90 planerizes an upper surface of the ultraviolet curable resin ejected by inkjet head 88, and makes a thickness of the ultraviolet curable resin uniform by, for example, evening out the surface of the ultraviolet curable resin while scraping off an excess resin with a roller or a blade. Additionally, irradiation device 92 includes a mercury lamp or an LED as a light source and irradiates the ejected ultraviolet curable resin with ultraviolet rays. **In** this manner, the ejected ultraviolet curable resin is cured to form a resin layer.

Third shaping unit 24 is a unit that shapes a connection section between an electrode of the electronic component and the wiring line on the circuit board, and includes third printing section 100. Third printing section 100 includes dispenser (refer to Fig. 2) 106, and dispenser 106 ejects conductive paste. The conductive paste is a conductive paste in which micrometer-sized metal particles are dispersed in a resin to be cured by relatively low-temperature heating. Incidentally, the metal particles have a flake shape, and viscosity of the conductive paste is relatively higher compared to that of the metal ink. The amount of the conductive paste ejected from dispenser 106 is controlled by an inner diameter of a needle, a pressure during ejection, and an ejection time.

The conductive paste ejected by dispenser 106 is heated by heater 66 incorporated into base plate 60. In the heated conductive paste, the resin is cured. At this time, in the conductive paste, the resin is cured and contracted, and the dispersed flake-shaped metal particles come into contact with the resin. Consequently, the conductive paste exhibits conductivity. In addition, the resin of the conductive paste is an organic adhesive, and exhibits an adhesive force when cured by heating.

Fourth shaping unit 25 is a unit that shapes a resin for fixing the electronic component to the circuit board, and includes fourth printing section 110. Fourth printing section 110 includes dispenser (refer to Fig. 2) 116, and dispenser 116 ejects a thermosetting resin. The thermosetting resin is a resin to be cured by heating. Dispenser 116 employs, for example, a piezoelectric method using a piezoelectric element. The thermosetting resin ejected from dispenser 116 is heated by heater 66 incorporated into base plate 60 and is cured.

Additionally, mounting unit 27 is a unit that mounts the electronic component on the circuit board, and includes supply section 130 and mounting section 132. Supply section 130 includes multiple tape feeders (refer to Fig. 2) 134 that feed taped electronic components one by one, and supplies the electronic component at a supply position. Supply section 130 is not limited to tape feeder 134 and may be a tray type supply device that supplies the electronic component by picking up the electronic component from a tray. Alternatively, supply section 130 may include both the tape type supply device and the tray type supply device, or other supply devices.

Mounting section 132 includes mounting head (refer to Fig. 2) 136 and movement device (refer to Fig. 2) 138. Mounting head 136 includes a suction nozzle (not illustrated) for picking up and holding the electronic component. The suction nozzle picks up and holds the electronic component by suctioning air through the supply of a negative pressure from a positive and negative pressure supply device (not illustrated). By supplying a slight positive pressure from the positive and negative pressure supply device, the electronic component is released. Additionally, movement device 138 moves mounting head 136 between the supply position of the electronic component by tape feeder 134 and the board placed on base plate 60. Consequently, in mounting section 132, the electronic component supplied from tape feeder 134 is held by the suction nozzle, and the electronic component held by the suction nozzle is mounted on the board.

In addition, control device 28 includes controller 140 and multiple drive circuits 142, as illustrated in Fig. 2. Multiple drive circuits 142 are connected to electromagnetic motors 38 and 56, holding device 62, lifting and lowering device 64, heater 66, inkjet head 76, infrared irradiation device 78, inkjet head 88, planarization device 90, irradiation device 92, dispenser 106, dispenser 116, tape feeder 134, mounting head 136, and movement device 138. Controller 140 includes CPU, ROM, RAM, or the like, mainly includes a computer, and is connected to multiple drive circuits 142. As a result, the operations of conveyance device 20, first shaping unit 22, second shaping unit 23, third shaping unit 24, fourth shaping unit 25, and mounting unit 27 are controlled by controller 140.

With the configuration described above, in circuit formation device 10, a resin laminate is formed on base plate 60, and a wiring line is formed on an upper surface of the resin laminate. Then, the electrodes of the electronic component are electrically connected to the wiring line via the conductive paste, and the electronic component is fixed by the resin. Further, a second resin laminate is formed to cover the resin laminate and the electronic component to form a circuit board.

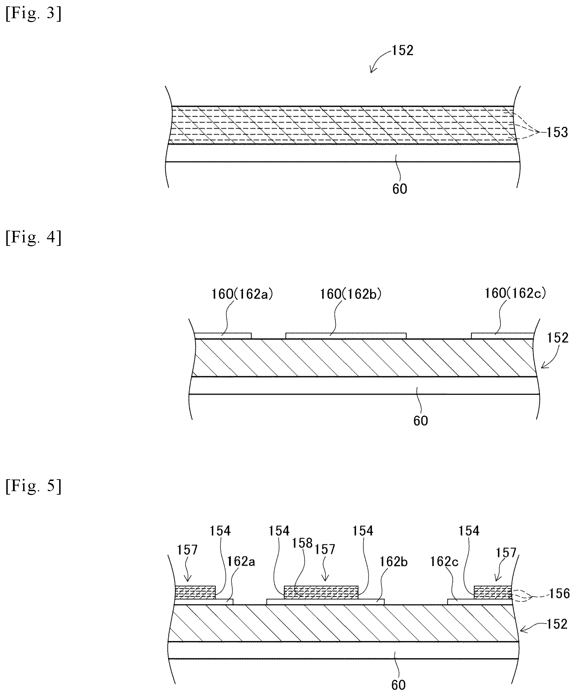

Specifically, first, stage 52 is moved below second shaping unit 23. Then, in second shaping unit 23, as illustrated in Fig. 3, resin laminate 152 is formed on base plate 60 of stage 52. Resin laminate 152 is formed by repeatedly ejecting the ultraviolet curable resin from inkjet head 88 and irradiating the ejected ultraviolet curable resin with ultraviolet rays from irradiation device 92.

In detail, in second printing section 84 of second shaping unit 23, inkjet head 88 ejects the ultraviolet curable resin in a thin film shape onto the upper surface of base plate 60. Subsequently, when the ultraviolet curable resin is ejected in a thin film shape, in curing section 86, the ultraviolet curable resin is planarized by planarization device 90 such that the ultraviolet curable resin has a uniform film thickness. Then, irradiation device 92 irradiates the thin film-shaped ultraviolet curable resin with ultraviolet rays. As a result, thin film-shaped resin layer 153 is formed on base plate 60.

Subsequently, inkjet head 88 ejects the ultraviolet curable resin in a thin film shape onto thin film-shaped resin layer 153. The thin film-shaped ultraviolet curable resin is planarized by planarization device 90, irradiation device 92 irradiates the ultraviolet curable resin ejected in a thin film shape with ultraviolet rays, thereby laminating thin film-shaped resin layer 153 on thin film-shaped resin layer 153. In this manner, by repeatedly ejecting the ultraviolet curable resin onto thin film-shaped resin layer 153 and irradiating the ultraviolet curable resin with ultraviolet rays and by laminating multiple resin layers 153, resin laminate 152 is formed.

Next, when resin laminate 152 is formed, stage 52 is moved below first shaping unit 22. Then, in first printing section 72 of first shaping unit 22, as illustrated in Fig. 4, inkjet head 76 linearly ejects metal ink 160 on an upper surface of resin laminate 152 in accordance with a circuit pattern. Subsequently, infrared irradiation device 78 irradiates metal ink 160 ejected in accordance with the circuit pattern with infrared rays in sintering section 74 of first shaping unit 22. Consequently, metal ink 160 is subjected to sintering, thereby forming wiring line 162 on the upper surface of resin laminate 152. In Fig. 4, three wiring lines 162 are formed, but in a case where three wiring lines 162 are distinguished from each other, the wiring line on the left side in Fig. 4 will be described as wiring line 162a, the wiring line at the center will be described as wiring line 162b, and the wiring line on the right side will be described as wiring line 162c.

Subsequently, when wiring line 162 is formed on resin laminate 152, stage 52 is moved below second shaping unit 23. Then, in second shaping unit 23, inkjet head 88 ejects the ultraviolet curable resin in a thin film shape such that end parts of three wiring lines 162 are exposed. Subsequently, when the ultraviolet curable resin is ejected in a thin film shape, in curing section 86, the ultraviolet curable resin is planarized such that the ultraviolet curable resin has a uniform film thickness. Then, irradiation device 92 irradiates the thin film-shaped ultraviolet curable resin with ultraviolet rays. As a result, as illustrated in Fig. 5, resin layer 156 is formed on resin laminate 152.

Subsequently, inkjet head 88 ejects the ultraviolet curable resin in a thin film shape only onto a portion on resin layer 156. That is, inkjet head 88 ejects the ultraviolet curable resin in a thin film shape onto resin layer 156 such that the end parts of three wiring lines 162 are exposed. The thin film-shaped ultraviolet curable resin is planarized by planarization device 90, and irradiation device 92 irradiates the ultraviolet curable resin ejected in a thin film shape with ultraviolet rays, thereby laminating resin layer 156 on resin layer 156. In this manner, by repeatedly ejecting the ultraviolet curable resin onto resin layer 156 and irradiating the ultraviolet curable resin with ultraviolet rays and by laminating multiple resin layers 156, resin laminate 157 is formed. As a result, resin laminate 157 is formed on resin laminate 152, and a step portion between resin laminate 152 and resin laminate 157 functions as cavity 154.

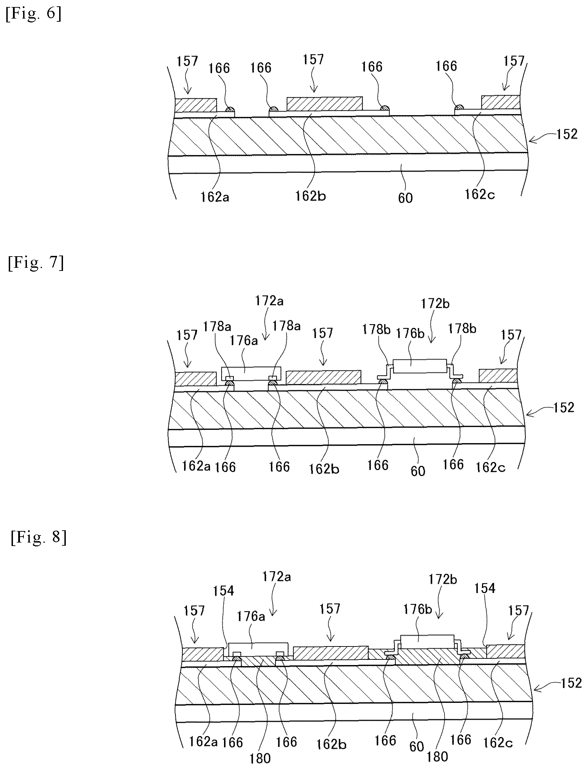

When resin laminate 157 is formed on resin laminate 152 in this manner, stage 52 is moved below third shaping unit 24. In third printing section 100 of third shaping unit 24, as illustrated in Fig. 6, dispenser 106 ejects conductive paste 166 onto both end parts of wiring line 162b, and onto end parts of wiring line 162a and wiring line 162c that face both end parts of wiring line 162b.

When conductive paste 166 is ejected onto the end part of wiring line 162 in this manner, resin laminate 152 is heated by heater 66 incorporated into base plate 60 in accordance with a heating condition of the conductive paste. Thus, conductive paste 166 is heated and cured through resin laminate 152, thereby exhibiting conductivity.

When conductive paste 166 ejected onto the end part of wiring line 162 is cured by heating in this manner, stage 52 is moved below mounting unit 27. In mounting unit 27, electronic component (refer to Fig. 7) 172 is supplied by tape feeder 134, and electronic component 172 is held by the suction nozzle of mounting head 136. Electronic component 172 includes component main body 176 and two electrodes 178. Mounting head 136 is moved by movement device 138, and electronic component 172 held by the suction nozzle is mounted on the upper surface of resin laminate 152 as illustrated in Fig. 7. In Fig. 7, two electronic components 172 are mounted on the upper surface of resin laminate 152. In one electronic component 172a of two electronic components 172, two electrodes 178a are disposed on the lower surface of component main body 176a. **In** other electronic component 172b of two electronic components 172, two electrodes 178b extend laterally from a pair of opposing side surfaces of component main body 176b, and then extend downward. Two electronic components 172a and 172b are mounted on the upper surface of resin laminate 152 such that electronic component 172a is electrically connected to two wiring lines 162a and 162b and electronic component 172b is electrically connected to two wiring lines 162b and 162c.

Specifically, electronic component 172a is mounted such that a lower surface of electrode 178a comes into contact with conductive paste 166, which has been cured on wiring lines 162a and 162b. Additionally, electronic component 172b is mounted such that a distal end of electrode 178 comes into contact with conductive paste 166, which has been cured on wiring lines 162b and 162c. That is, conductive paste 166 is ejected to the position where electrode 178 is to be mounted on wiring line 162, and electronic component 172 is mounted on resin laminate 152, whereby electrode 178 comes into contact with conductive paste 166, which has been cured on wiring line 162. In this manner, by mounting two electronic components 172a and 172b, electronic component 172a is electrically connected to two wiring lines 162a and 162b, and electronic component 172b is electrically connected to two wiring lines 162b and 162c.

Subsequently, stage 52 is moved below fourth shaping unit 25. In fourth printing section 110 of fourth shaping unit 25, dispenser 116 ejects thermosetting resin 180 between the lower surface of component main body 176 of electronic component 172 and the upper surface of resin laminate 152, as illustrated in Fig. 8. As a result, thermosetting resin 180 is sealed between the upper surface of resin laminate 152 and the lower surface of component main body 176 of electronic component 172. That is, thermosetting resin 180 is injected between the upper surface of resin laminate 152 and the lower surface of component main body 176. At this time, thermosetting resin 180 flows out from between the upper surface of resin laminate 152 and the lower surface of component main body 176 to a periphery of electronic component 172, and fills the inside of cavity 154. However, in cavity 154, thermosetting resin 180 is ejected so that the upper surface of thermosetting resin 180 has substantially the same height as the lower surface of component main body 176 of electronic component 172. That is, in cavity 154 in which electronic component 172a is mounted, thermosetting resin 180 is ejected so that the upper surface of thermosetting resin 180 has substantially the same height as the lower surface of component main body 176a of electronic component 172a. In addition, in cavity 154 in which electronic component 172b is mounted, thermosetting resin 180 is ejected so that the upper surface of thermosetting resin 180 has substantially the same height as the lower surface of component main body 176b of electronic component 172b.

A height dimension of resin laminate 157 partitioning cavity 154 is a height dimension in which thermosetting resin 180 injected into cavity 154 does not overflow. That is, the height dimension of resin laminate 157 is set to be higher dimension than the lower surface of component main body 176 of electronic component 172 mounted in cavity 154. When thermosetting resin 180 is thus ejected into cavity 154, thermosetting resin 180 is heated by heater 66 incorporated into base plate 60 in accordance with the heating condition of the thermosetting resin. Consequently, thermosetting resin 180 is heated and cured through resin laminate 152.

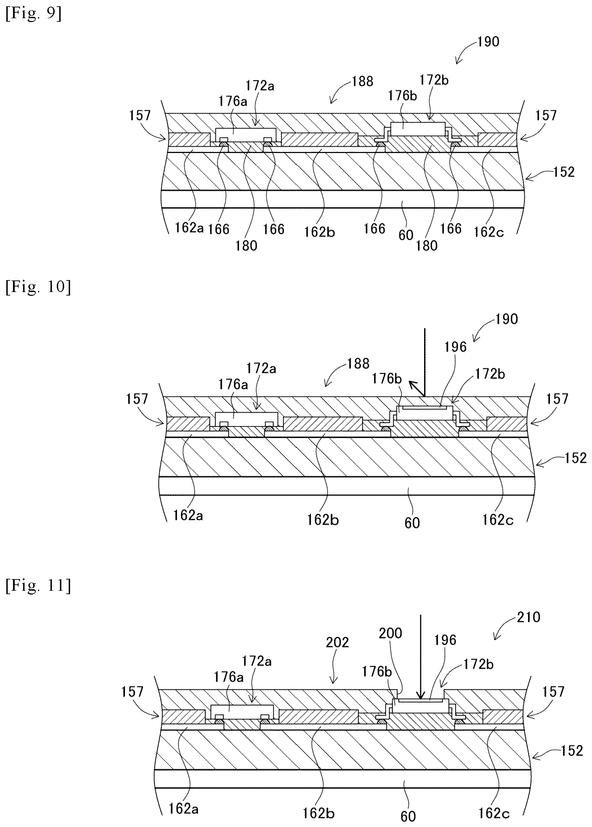

When thermosetting resin 180 ejected into cavity 154 is cured, stage 52 is moved below second shaping unit 23. In second shaping unit 23, as illustrated in Fig. 9, resin laminate 188 is formed on resin laminate 152 and resin laminate 157. Resin laminate 188 is formed by the same method as that of resin laminate 152. That is, by repeatedly ejecting ultraviolet curable resin onto resin laminate 152 and resin laminate 157, planarizing the surface of the ultraviolet curable resin, and curing the ultraviolet curable resin, resin laminate 188 is formed. In addition, when resin laminate 188 is formed, the ultraviolet curable resin is also ejected into cavity 154 and onto electronic component 172, and resin laminate 188 extending upward from the upper surface of electronic component 172 is formed. That is, the ultraviolet curable resin is ejected to cover the inside of cavity 154 and entire electronic component 172, and resin laminate 188 containing entire electronic component 172 is formed.

In this way, resin laminate 188 containing entire electronic component 172 is formed on resin laminate 152 and resin laminate 157, whereby circuit board 190 is formed. In such circuit board 190, since resin laminate 188 contains electronic component 172, electronic component 172 can be sealed in circuit board 190 to prevent foreign matter from entering electronic component 172. In addition, for example, a wiring line or the like can be further formed on the upper surface of resin laminate 188, the electronic component can be mounted, and many electronic components can be mounted on the circuit board.

However, some of electronic components 172 exhibit a predetermined function, and a functional section for exhibiting the predetermined function is disposed on the upper surface of electronic component 172. For example, the functional section performs input, output, or the like, and the electronic component having the functional section functions as a detection sensor, an LED, a connector, a speaker, or the like based on input, output, or the like of light, signal, sound, or the like. Therefore, for example, an infrared sensor includes a detection section for detecting infrared rays, and detects the infrared rays in the detection section. Specifically, when electronic component 172b is an infrared sensor, as illustrated in Fig. 10, detection section 196 is disposed on the upper surface of electronic component 172b, that is, on the upper surface of component main body 176b. In this way, when detection section 196 is disposed on the upper surface of electronic component 172b, electronic component 172b cannot detect the infrared rays in circuit board 190. That is, in circuit board 190, electronic component 172b is sealed and the entire upper surface of electronic component 172b is covered with resin laminate 188, so that the infrared rays through resin laminate 188 does not pass through resin laminate 188 and detection section 196 cannot detect the infrared rays. Therefore, electronic component 172b cannot exhibit the function as an infrared sensor on circuit board 190. Since electronic component 172a is a general electronic component and does not have a functional section that exhibits a predetermined function such as a detection function on the upper surface, electronic component 172a may be sealed in circuit board 190. In the following description, an electronic component having a functional section may be referred to as a functional component, and a component having no functional section may be referred to as a general component.

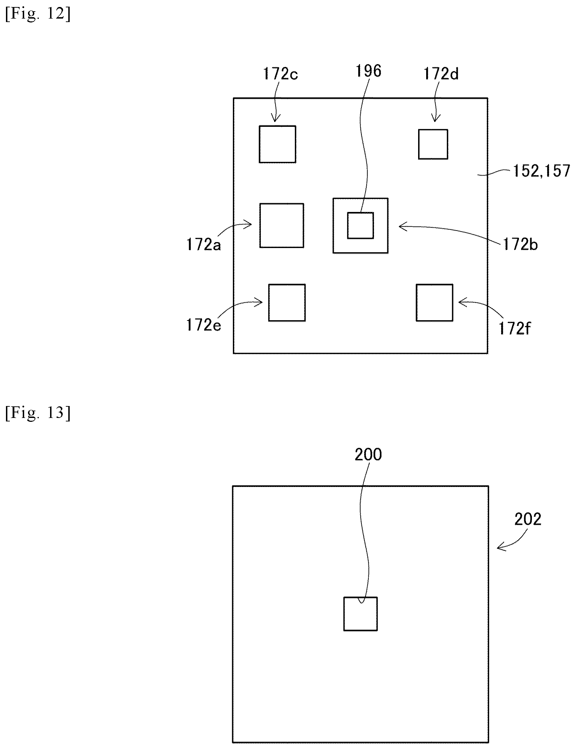

In circuit formation device 10, as illustrated in Fig. 11, resin laminate 202 including opening 200 for exposing detection section 196 of electronic component 172b is formed on resin laminate 152 and resin laminate 157. Specifically, image data of resin laminate 202 including opening 200 for exposing detection section 196 of electronic component 172b is generated. For example, as illustrated in Fig. 12, when six electronic components 172a to 172f are mounted on resin laminates 152 and 157, the position of the functional component among six electronic components 172a to 172f is specified, and the position of the functional section of the functional component is specified. Here, electronic component 172b of six electronic components 172a to 172f is the functional component, electronic components 172a and 172c to 172f of six electronic components 172a to 172f are the general components. Therefore, the position of detection section 196 of electronic component 172b is specified. Then, as illustrated in Fig. 13, opening 200 is formed at the position of detection section 196, and the image data of resin laminate 202 that covers entire resin laminates 152 and 157 is generated. An inner dimension of opening 200 is a dimension larger than an outer edge of detection section 196 and smaller than an outer edge of electronic component 172b. Therefore, the image data of resin laminate 202 that exposes only detection section 196 of electronic component 172b, covers entire electronic components 172a and 172c to 172f and resin laminate 152 and 157, and covers the edge parts other than detection section 196 of electronic component 172b is generated.

Then, as illustrated in Fig. 11, resin laminate 202 in which only electronic component 172b, that is, detection section 196 of the functional component is exposed from opening 200 is formed by ejecting the ultraviolet curable resin from inkjet head 88 in second shaping unit 23 in accordance with the generated image data. At this time, inkjet head 88 ejects the ultraviolet curable resin to surround a side surface of electronic component 172b in a state in which the ultraviolet curable resin is in close contact with the side surface and to cover the upper surfaces of resin laminates 152 and 157 and the edge parts excluding detection section 196 of electronic component 172b. Thus, resin laminate 202 extending upward from the upper surface of electronic component 172b is formed in a state where detection section 196 of electronic component 172b is exposed.

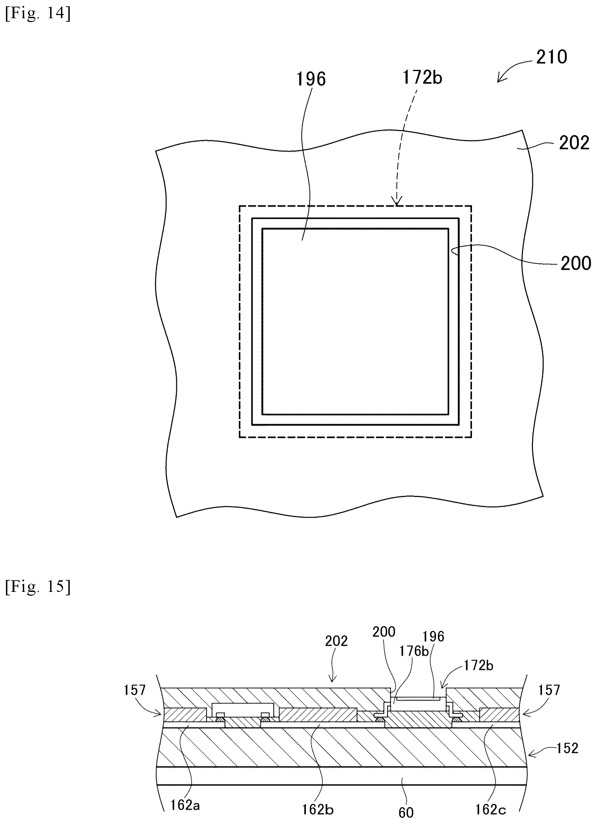

In circuit board 210 on which such resin laminate 202 is formed, it is possible to detect an infrared ray by exposed detection section 196, and electronic component 172b can exhibit a function as an infrared sensor. In circuit board 210, resin laminate 202 extends upward from the upper surface of electronic component 172b. Accordingly, electronic component 172b can be more appropriately protected by resin laminate 202. In circuit board 210, as shown in Fig. 14, edge parts other than detection section 196 of electronic component 172b are covered with resin laminate 202. As a result, it is possible to prevent foreign matter from entering portions other than detection section 196 of electronic component 172b. Since electronic components 172a, 172c to 172f other than electronic component 172b, that is, the general components are entirely covered by resin laminate 202, entry of foreign matter into general components is also prevented. Furthermore, since the edge parts other than detection section 196 of electronic component 172b are covered with resin laminate 202, an area of the upper surface of resin laminate 202 can be increased, and many components can be mounted on the upper surface of resin laminate 202.

As shown in Fig. 2, controller 140 of control device 28 includes mounting section 220, image data generation section 222, and resin laminate forming section 224. Mounting section 220 is a functional section for mounting electronic components 172 in cavities 154 of resin laminates 152 and 157. Image data generation section 222 is a functional section for generating image data of resin laminate 202 having opening 200. Resin laminate forming section 224 is a functional section for forming resin laminate 202 based on the image data generated by image data generation section 222.

In the above example, second shaping unit 23 is an example of a device for forming a resin laminate. Resin laminates 152 and 157 are examples of a base. Cavity 154 is an example of a cavity. Electronic component 172b is an example of the component. Detection section 196 is an example of a functional section. Resin laminate 202 is an example of a resin laminate. Circuit board 210 is an example of a circuit board. In addition, a step executed by mounting section 220 is an example of a mounting step. The step performed by image data generation section 222 is an example of an image data generating step. The step performed by resin laminate forming section 224 is an example of a resin laminate forming step.

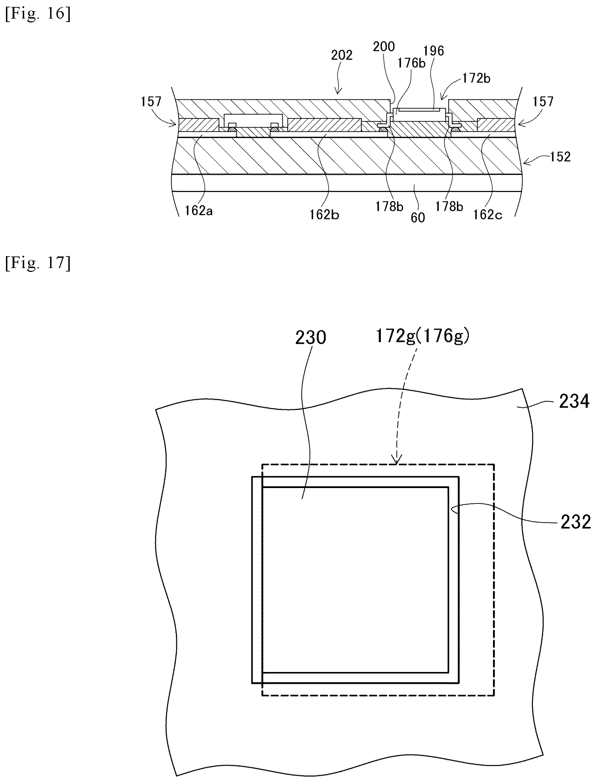

The present invention is not limited to the above example and can be performed in various aspects in which various modifications and improvements are made based on the knowledge of those skilled in the art. For example, in the above example, the edge parts other than detection section 196 of electronic component 172b are covered with resin laminate 202; however, as illustrated in Fig. 15, the upper surface of electronic component 172b need not be covered with resin laminate 202. That is, the entire upper surface of component main body 176b of electronic component 172b including detection section 196 may be exposed from opening 200 of resin laminate 202. In addition, in the above example, the side surface of electronic component 172b is surrounded in a state in which the side surface is in close contact with resin laminate 202; however, as illustrated in Fig. 16, the side surface of electronic component 172b need not be in close contact with resin laminate 202. That is, as long as resin laminate 202 surrounds the side surface of electronic component 172b, a clearance may be formed between resin laminate 202 and the side surface of electronic component 172b. It is desirable that the clearance between resin laminate 202 and the side surface of electronic component 172b be small, for example, it is desirable that the clearance between resin laminate 202 and the side surface of electronic component 172b be small enough so that electrode 178b of electronic component 172b is covered with resin laminate 202.

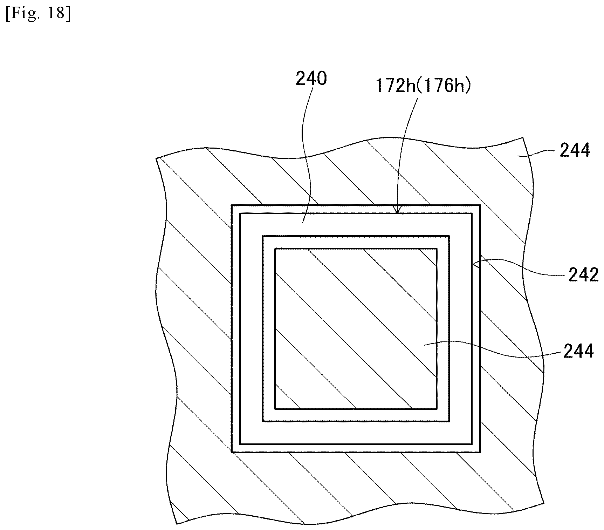

Further, in the above example, as illustrated in Fig. 14, the edge parts of electronic component 172b other than detection section 196, that is, the edge parts of the four sides of the upper surface of electronic component 172b are covered with resin laminate 202; however, one or more edge parts of the four sides of the upper surface of electronic component 172b may be covered with resin laminate. Specifically, for example, as illustrated in Fig. 17, in electronic component 172g, functional section 230 is disposed at a position including the edge part of one side of the upper surface of component main body 176g. In such electronic component 172g, in order to expose functional section 230 from opening 232, edge parts of three sides of the four sides of the upper surface of component main body 176g excluding one side where functional section 230 is disposed may be covered with resin laminate 234. Further, for example, as illustrated in Fig. 18, in electronic component 172h, functional section 240 is disposed along the four sides of the upper surface of component main body 176h. In such electronic component 172h, in order to expose functional section 240 from opening 242, all edge parts of the four sides of the upper surface of component main body 176h need not be covered with resin laminate 244. However, resin laminate 244 may cover a portion of the upper surface of electronic component 172h excluding functional section 240, that is, a central portion of the upper surface of electronic component 172h, for the purpose of preventing entry of foreign matter and increasing the area of the upper surface of resin laminate 244. That is, resin laminate 244 may cover at least a part of the upper surface of electronic component 172h excluding the functional sections. In Fig. 18, in order to clarify the position of resin laminate 244, resin laminate 244 is indicated by diagonal lines.

Further, in the above example, resin laminate 202 that exposes the upper surface of the functional component from opening 200 is formed; however, the resin laminate that exposes the upper surface of the general component from the opening may be formed. At this time, the resin laminate may surround the side surface of the general component and extend upward from the upper surface of the general component. The resin laminate may cover at least a part of the upper surface of the general component or need not cover the upper surface of the general component. In this way, by exposing the upper surface of the general component from the opening, for example, heat dissipation of the component and the like can be efficiently performed.

In the above example, electronic component 172a is mounted in cavity 154 of resin laminate 152 and 157 functioning as a base, and electronic component 172a is exposed from opening 200. On the other hand, a component other than the electronic component, for example, a component not electrically connected may be mounted in the cavity of the base, and the component may be exposed from the opening.

In addition, in the above example, the ultraviolet curable resin is adopted as the resin forming resin laminates 152, 157, and 202, and the thermosetting resin is adopted as the resin for fixing electronic component 172 inside cavity 154. That is, the resin for forming resin laminates 152, 157, and 202 and the resin for fixing electronic component 172 are different curable resins, but the resin for forming resin laminates 152, 157, and 202 and the resin for fixing electronic component 172 may be the same curable resin.

### Reference Signs List

23: Second shaping unit (resin laminate forming device), 152: Resin laminate (base), 157: Resin laminate (base), 154: Cavity, 172b: Electronic component (component), 196: Detection section (functional section), 202: Resin laminate, 210: Circuit board (electric circuit), 220: Mounting section (mounting step), 222: Image data generation section (image data generating step), 224: Resin laminate forming section (resin laminate forming step).

## Claims

1. A resin laminate forming device, wherein
a resin laminate is formed to extend upward from an upper surface of a component mounted in a cavity formed in a base in a state in which the upper surface of the component is exposed by ejecting a curable resin to surround a side surface of the component and to cover an upper surface of the base.

2. The resin laminate forming device according to Claim 1, wherein
the resin laminate is formed to extend upward from the upper surface of the component in a state in which the upper surface of the component is exposed by ejecting the curable resin to surround the side surface in a state in which the curable resin is in close contact with the side surface of the component and to cover the upper surface of the base.

3. The resin laminate forming device according to Claim 1 or 2, wherein
the resin laminate is formed to extend upward from the upper surface of the component in a state in which a part of the upper surface of the component is exposed by ejecting the curable resin to surround the side surface of the component and to cover the upper surface of the base and the part of the upper surface of the component.

4. The resin laminate forming device according to Claim 3, wherein
the component includes, on the upper surface of the component, a functional section configured to exhibit a function of the component, and
the resin laminate is formed to extend upward from the upper surface of the component in a state in which the functional section on the upper surface of the component is exposed by ejecting the curable resin to surround the side surface of the component and to cover the upper surface of the base and at least a part of a portion excluding the functional section on the upper surface of the component.

5. A circuit board comprising:
a base having a cavity;
a component mounted in the cavity; and
a resin laminate formed of a curable resin ejected to surround a side surface of the component and to cover an upper surface of the base,
wherein the resin laminate extends upward from an upper surface of the component in a state in which the upper surface of the component is exposed.

6. A circuit board forming method comprising:
a mounting step of mounting a component in a cavity formed in a base; and
a resin laminate forming step of forming a resin laminate that extends upward from an upper surface of the component in a state in which the upper surface of the component is exposed by ejecting a curable resin to surround a side surface of the component and to cover an upper surface of the base.

7. The circuit board forming method according to Claim 6, further comprising:
an image data generating step of generating image data of the resin laminate having an opening for exposing the upper surface of the component,
wherein in the resin laminate forming step, the resin laminate is formed based on the image data generated in the image data generating step.
